(19) Europäisches Patentamt
European Patent Office
Office européen des brevets

(11) **EP 4 045 695 B1**

(12) **EUROPÄISCHE PATENTSCHRIFT**

(45) Veröffentlichungstag und Bekanntmachung des Hinweises auf die Patenterteilung:
**18.12.2024   Patentblatt 2024/51**

(21) Anmeldenummer: **20800017.4**

(22) Anmeldetag: **15.10.2020**

(51) Internationale Patentklassifikation (IPC):
**B08B 9/24** *(2006.01)*      **B08B 9/30** *(2006.01)*
**C23C 16/02** *(2006.01)*      **C23C 16/517** *(2006.01)*

(52) Gemeinsame Patentklassifikation (CPC):
**C23C 16/0227; C23C 16/517;** B08B 9/24;
B08B 9/30

(86) Internationale Anmeldenummer:
**PCT/EP2020/079055**

(87) Internationale Veröffentlichungsnummer:
**WO 2021/074302 (22.04.2021 Gazette 2021/16)**

(54) **VORRICHTUNG UND VERFAHREN ZUM RECYCLEN VON GETRÄNKEFLASCHEN AUS KUNSTSTOFF**

APPARATUS AND METHOD FOR RECYCLING DRINKS BOTTLES MADE FROM PLASTIC

APPAREIL ET PROCÉDÉ DE RECYCLAGE DE BOUTEILLES DE BOISSON EN PLASTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.10.2019   DE 102019127845**

(43) Veröffentlichungstag der Anmeldung:
**24.08.2022   Patentblatt 2022/34**

(73) Patentinhaber:
• **KHS GmbH**
**44143 Dortmund (DE)**
• **Vereinigung zur Förderung des Instituts für Kunststoffverarbeitung in Industrie und Handwerk**
**An der Rhein.- Westf. Technischen Hochschule**
**52074 Aachen (DE)**

(72) Erfinder:
• **KYTZIA, Sebastian**
**23826 Todesfelde (DE)**
• **KONRAD, Joachim**
**40627 Düsseldorf (DE)**
• **VOGELSANG, Andreas**
**22145 Hamburg (DE)**
• **JARITZ, Montgomery**
**52074 Aachen (DE)**
• **DAHLMANN, Rainer**
**52146 Würselen (DE)**

(74) Vertreter: **Eisenführ Speiser Patentanwälte Rechtsanwälte PartGmbB Johannes-Brahms-Platz 1 20355 Hamburg (DE)**

(56) Entgegenhaltungen:
**WO-A1-2009/124688      DE-A1- 102012 213 079 US-A- 5 849 366**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft eine Anlage zur Reinigung und Behandlung von Behältern. Weiterhin betrifft die Erfindung ein entsprechendes Verfahren zur Reinigung und Behandlung von Behältern.

Es ist bekannt, dass im Rahmen von Pfand- und Rückführungssystem (Mehrwegsystemen) Kunststoffbehälter, insb. PET-Behälter von Endverbrauchern über entsprechende Sammel-und Rücknahmesysteme einer Anlage zur Reinigung und Wiederbefüllung mit einem Produkt, insbesondere mit einem Getränk, zugeführt werden. Hierzu ist es weiterhin bekannt, dass industrielle Behälterreinigungsmaschinen eingesetzt werden.

Diese weisen unterschiedliche Behandlungsabschnitte auf, in denen die Behälter mit unterschiedlichen Prozessmedien gereinigt und behandelt werden. Diese Prozessmedien sind neben Wasser zum finalen Abspritzen der Behälter insbesondere Laugen- und/oder Säurebäder. In der WO 2009/118139 A1 oder der WO 2009/124688 A1 sind derartige industriell übliche Flaschenreinigungsmaschinen offenbart.

Da diese Prozessmedien starke Einwirkungen auf das Kunststoffmaterial ausüben und bspw. zu Porenbildung führen und die oberen Strukturen aufrauen, müssen Kunststoffbehälter für diese unmittelbare Wiederverwendung deutlich höhere Wandstärken aufweisen, als bspw. PET-Einwegbehälter. Daher können Kunststoffbehälter nur begrenzt auf diesem Weg unmittelbar wiederverwendet werden.

Aus der vorveröffentlichten Patentanmeldung DE 10 2012 213079 A1 sind Vorrichtungen bekannt, mit denen Behälter bedruckt werden. Zur Vorbereitung werden diese zunächst gereinigt und gegebenenfalls beschichtet.

Aus der vorveröffentlichten Patentanmeldung US 5 849 366 A ist bekannt, Behälter mit Beschichtungen zu versehen, um deren Beständigkeit zu verbessern.

Eine Aufgabe der vorliegenden Erfindung besteht demnach darin, eine Anlage bereit zu stellen, mittels welcher Behälter derart behandelt werden können, dass eine möglichst häufige Wiederverwendung als Primärverpackung möglich ist.

Diese Aufgabe wird erfindungsgemäß gelöst durch die Merkmale des Anspruchs 1, wobei ein erfindungsgemäßes Verfahren durch die Merkmale des Anspruchs 8 gelöst wird. Vorteilhafte Ausgestaltungen sind in den Unteransprüchen angegeben.

Dabei liegt der Kern darin, dass auch die zur Wiederbefüllung vorgesehen Behälter beschichtet werden, um so die Resistenz des Behältermaterials gegenüber den vor einer Wiederbefüllung erforderlichen Reinigungsschritten mit aggressiven Medien hinreichend zu erhöhen. Überraschenderweise konnte dabei herausgefunden werden, dass Schichtsysteme, die als Gasbarriere für Einweg-Kunststoffbehälter zur Verhinderung von Sauerstoffeintrag (O2) oder Kohlenstoffaustrag (CO2) durch die Behälterwand hierfür dem Grunde nach geeignet sind. Weiterhin konnte herausgefunden werden, dass es möglich und vorteilhaft ist, bereits beschichtete Behälter nach der Reinigung erneut mit einer vollständigen Beschichtung zu versehen.

Damit kann die Durchlaufhäufigkeit von Kunststoffflaschen in den Rücknahme- und Pfandsystemen vervielfacht werden, gegenüber den bestehenden Systemen von unbeschichteten Pfandflaschen aus Kunststoff.

Vorliegend sollen unter Pfand- und Rückführungssystemen nur solche Systeme verstanden werden, bei denen die Behälter in ihrer Form und Geometrie erhalten bleiben. Ein Pfand-und Rückführungssystem, bei welchem die Behälter zerstört oder temporär strukturmäßig verändert werden, in dem diese bspw. zu einem Granulat verarbeitet und erneut produziert werden, soll vorliegend nicht gemeint sein.

Bei der erfindungsgemäßen Anlage zur Behandlung von Behältern aus Kunststoff, ist mind. eine Reinigungsmaschine umfasst. Diese Reinigungsmaschine weist mehrere Behandlungsabschnitte auf, in welchen unter anderem das Behälterinnere mit flüssigen Medien gespült und/oder ausgesprüht werden kann. Dabei ist mindestens einer der Behandlungsabschnitte eine Laugenbehandlung/-bad bspw. mit Natronlauge (Na-OH), wobei dieser Behandlungsabschnitt eine Heizeinrichtung aufweist und/oder mit einer solchen verbunden ist. Dabei kann die Verbindung auch darin bestehen, dass die Lauge separat erwärmt wird und dann mit einer erhöhten Temperatur dem Behandlungsabschnitt zugeleitet wird. Zudem ist immer ein weiterer Behandlungsschritt vorgesehen, bei welchem die Behälter mit Wasser behandelt werden, insbesondere abgesprüht oder ausgeschwemmt. Die Behälter selbst sind regelmäßig aus PET, können aber auch aus einem anderen Kunststoff bestehen, wie PE, HDPE, PP oder POC.

Die Anlage weist stromabwärts der Reinigungsmaschine als wesentliches Element eine Beschichtungsvorrichtung auf, und die Behälter können mittels geeigneter Transportmittel von der Reinigungsmaschine zur Beschichtungsvorrichtung transportiert werden. Die Transportmittel können ein- oder mehrteilig sein. Insbesondere kann es vorteilhaft sein, dass anfänglich ein Massentransport erfolgt und nachfolgend die Behälter vereinzelt gehalten und transportiert werden, bspw. mittels rotierender Transportsterne.

Bei einer verbesserten Variante ist zwischen der Reinigungsmaschine und der Beschichtungsvorrichtung eine weitere Behandlungsmaschine vorgesehen ist, mit welcher die Behälter für die Beschichtung konditioniert werden. Dies kann insbesondere eine Trocknungsvorrichtung sein, in der Restfeuchtigkeit in Form von Tropfen, Kondensat oder Dampf aus dem Behälter ausgeleitet wird. Hierzu kann es vorteilhaft sein, wenn zugehörig zur Trocknungsvorrichtung stromaufwärts und stromabwärts hierzu, mindestens eine Wendevorrichtung für Behälter vorgesehen ist, und die Behälter in der

Trocknungsvorrichtung mittels Führungsgeländer und/oder Greifelementen derart gehalten werden, dass die Behältermündung vertikal nach unten weist, so dass Flüssigkeit ablaufen kann.

Erfindungsgemäß ist vorgesehen, dass zwischen der Reinigungsmaschine und der Beschichtungsvorrichtung außer einer Trocknungsvorrichtung und ggf. zugehörige Transport- oder Wendevorrichtungen keine weiteren Behandlungselemente für die Behälter angeordnet sind. Es können allerdings eine oder mehrere Inspektionseinrichtungen mit ggf. erforderlichen Ausleitelementen zwischen Reinigungsmaschine und Beschichtungsvorrichtung vorgesehen werden, die vorliegend nicht als Behandlungselemente betrachtet werden sollen, ebenso wie diese stromaufwärts zur Reinigungsmaschine vorgesehen werden können.

Natürlich kann die Anlage stromabwärts der Beschichtungsvorrichtung weitere Maschinen zum Behandeln von Behältern aufweisen, insbesondere einen Füller, einen Verschließer, eine Dekoriermaschine, wie eine Bedruckungsvorrichtung oder einen Etikettierer und/oder eine Verpackungsmaschine. Hier sind nachfolgend alle bekannten Elemente für die Behälterbehandlung bedarfsweise denkbar.

In der vorgenannten Anlage, ist die Beschichtungsvorrichtung eine Gasabscheidevorrichtung mittels Plasma, welche mehrere Vakuumkammern aufweist, in welchen die Behälter einzeln oder gruppenweise aufgenommen werden und unter Vakuum beschichtet werden können. Hierzu führen in jede Vakuumkammer mindestens eine Gasleitung, die wiederum leitungsmäßig mit mindestens zwei unterschiedlichen Prozessgasquellen verbunden sind. Dabei ist zur Plasma-Bildung mindestens ein Mikrowellengenerator oder mindestens ein Hochfrequenzgenerator vorgesehen

Bei einer Ausführungsvariante ist eine der Prozessgasquellen mindestens ein Gastanktank für Hexamethyldisilazane (HMDSN), Hexamethyldisiloxane (HMDSO) oder Acetylen (Ethin) oder diese Prozessmedien werden in flüssiger Form vorgehalten, so dass ein Flüssigkeitstank mit einer Verdampfereinheit umfassen ist. Derartige Systeme zur Aufbereitung einer Precursor-Flüssigkeit sind dem Grunde nach aus dem Stand der Technik bekannt. Weiterhin ist mindestens eine Zuleitung für eines der folgenden Gase vorgesehen: Sauerstoff (O2), Stickstoff (N2) oder ein Edelgas, wie insb. Argon (Ar), aber auch Helium (He) oder Xenon (Xe). Vorrangig sind Zuleitungen für O2, N2 und ein Edelgas vorgesehen.

Von der Erfindung ist auch ein Verfahren zur Behandlung von Behältern aus Kunststoff umfasst, insbesondere Behälter aus PET, PE, PP oder POC, bei dem in einem ersten Schritt die Behälter, insbesondere das jeweilige Behälterinnere, mittels flüssiger Behandlungsmedien gereinigt werden, wobei mindestens eines der Behandlungsmedien eine Lauge ist, wie NaOH-Lauge, und mindestens ein Behandlungsmedium Wasser ist.

Dabei können weitere bekannte Reinigungsschritte mittels Säurebädern oder Mehrfachbehandlungen erfolgen, bei verbesserten Reinigungsverfahren.

In dem einem nachfolgenden Schritt werden die Behälter, insbesondere die Behälterinnenwände, beschichtet, nämlich mittels eines PCVD-Verfahrens mit mindestens zwei Schichten, insbesondere Schichten auf der inneren Oberfläche der Behälter, und insbesondere wird das Plasma mittels Mikrowellengenerator oder Hochfrequenzgenerator induziert. Dabei ist unter Beschichtung ein Auftrag aus mehreren Schichten zu verstehen, die auch das Aufbringen von mehreren Schichten mit unterschiedlichen Funktionen und/oder Zusammensetzungen umfasst. Diese Funktionen können beispielsweise Haftvermittlung (Haftvermittlerschicht, Base Coat), Barriere (Sperrschicht) und Sicherung (Top-Coating, Sicherungsschicht) sein wobei diese auch jeweils mehrfach vorgenommen werden können, je nach dem, wie hochwertig die Beschichtung des wiederverwendbaren Behälters final sein soll.

Idealerweise haben die Behälter vorlaufend zum ersten Schritt der Reinigung ein Pfand-und Rückführungssystem durchlaufen und werden als vollständige Behälter zum ersten Schritt transportiert.

Bei einem verbesserten Verfahren weisen die Behälter bereits vor dem ersten Schritt der Reinigung eine mindestens teilflächige Beschichtung der inneren Oberfläche auf, die auch als Mehrschichtsystem ausgebildet sein kann.

Der Vorteil liegt hierbei darin, dass die Behälterinnenwand vor den aggressiven Reinigungsmedien geschützt wird. Es hat sich nämlich überraschenderweise gezeigt, dass eine mehrfache Beschichtung jederzeit möglich ist, auch wenn eine vorliegende Beschichtung ggf. unvollständig oder schadhaft ist. Weiterhin sichert eine Beschichtung auch von Neuflaschen langfristig die Qualität der Kunststoffoberfläche, so dass diese bei einem ersten Reinigungsdurchlauf und nachfolgender Beschichtung leichter wiederbeschichtet werden können.

Bei dem vorgenannten Verfahren oder dessen Ausführungsformen werden die Behälter mittels eines Gasabscheideverfahrens, nämlich ein PCVD-Verfahren mit mindestens zwei Schichten beschichtet, die insbesondere auf der inneren Oberfläche der Behälter abgeschieden werden. Die Plasma-Zündung oder -induzierung erfolgt dabei vorteilhafterweise mittel mindestens einem Mikrowellengenerator (MW) oder einem Hochfrequenzgenerator (RF).

Bei einer vorteilhafen Variante des Verfahrens, bei welcher der Generator zur Plasma-Induzierung eine Mikrowellengenerator ist, hat ich überraschenderweise gezeigt, dass die Widerstandfähigkeit gegen Laugeneinflüsse verbessert wird, wenn der mittlere Energieeintrag bei der Beschichtung niedrig ist, nämlich wenn der mittlere Energieeintrag aus aktiver Pulszeit zur Gesamtpulszeit multipliziert mit der Generatorleistung im Bereich von 10 bis 120 Watt liegt, idealerweise im Bereich von 20 bis 100 Watt.

Dabei hat sich weiterhin gezeigt, dass es vorteilhaft ist, wenn bei niedrigem Energieeintrag die aktive Pulszeit im Bereich von 0.1 ms bis 1 ms liegt und das Verhältnis von aktiver Pulszeit zur Gesamtpulszeit im Bereich von 0,01 bis 0,05 liegt.

So liegt bei einem Test mit sehr guter Widerstandswerten gegen NaOH die Pulszeit bei 0,5 ms, die Puls-Pausezeit 20 ms und die Mikrowellenleistung bei 1,8 kW, so dass sich der mittlere Energieeintrag $E_m$ wie folgt berechnet:

$$E_m = 0,5\ ms\ /\ 20,5\ ms\ *\ 1,8\ kW = 24,39\ W.$$

Bei dem Alternativen Verfahren, bei welchem der Generator zur Plasma-Induzierung eine Hochfrequenzgenerator ist, wurde ein vergleichbarer, vorteilhafter Bereich für den mittlerem Energieeintrag von 10 bis 120 Watt beobachtet, der idealerweise im Bereich von 20 bis 100 Watt liegt.

Diese Beobachtung ist sehr überraschend, weil der mittlere Energieeintrag für das vorbekannte Verfahren und die Vorrichtung zur Erzeugung einer guten Gasbarriere im Bereich von 210 bis 450 Watt liegt.

Eine besonders vorteilhafte Verfahrensvariante besteht darin, dass die neu produzierten Behälter in einem vorlaufenden Schritt mit einem Mehrschichtsystem vor der ersten Befüllung und idealerweise unmittelbar nach dem Produktion versehen werden. Diese Mehrschichtsystem ist mindestens ein Dreischichtensystem aus Haftvermittler (Base Coating), Barriereschicht (Barrier Coating) und Schutzschicht (Top Coat).

Nach der Verwendung bspw. durch Endverbraucher und Rückführung der Behälter über ein Pfand- und Rückführungssystem, werden die Behälter wie vorstehend beschrieben mittels einer Reinigungsmaschine gereinigt und anschließend nur noch teilweise neu bzw. ergänzend beschichtet, nämlich nur noch

- mit der Barriereschicht (Barrier Coating) und der Schutzschicht (Top Coat) oder
- idealerweise wird nur die äußerste Schicht, insb. die Schutzschicht (Top Coat) erneut aufgebracht.

Überraschenderweise hat sich gezeigt, dass die nasse Reinigungsbehandlung der Behälter zwar teilweise auch die Beschichtung beschädigen kann, aber keinen nachteiligen Einfluss auf eine derartige ergänzende Beschichtung hat.

Der Vorteil einer nur teilweisen bzw. ergänzenden Beschichtung besteht darin, dass damit bekannt Beschichtungsvorrichtungen durch den Wegfall der ersten Beschichtungsschritte bei deutlich erhöhter Leistung betrieben werden können.

Der Unterschied in der Formulierung einer Barriereschicht und einer Schutzschicht ist im Stand der Technik dem Grunde nach bekannt, und besteht prozessseitig darin, dass bspw. der HDMSO- oder HDMSN-Fluss beim Auftrag der Schutzschicht mind. das 1,5-fache bis zum 4-fachen beträgt, verglichen zum Gasfluss bei der Aufbringung der Barriereschicht.

Weiterhin hat es sich als vorteilhaft herausgestellt, wenn die Temperatur mindestens eines der Behandlungsmedien für die Behälter, welches eine Lauge ist, im Bereich von 30°C bis 70°C liegt, idealerweise im Bereich von 40°C bis 60°C. Die vorgenannten Schichten sind bei diesen Laugen-Temperaturen hierfür hinreichend widerstandsfähig und bieten somit den nötigen Schutz für das Wandmaterial der Behälter. Zeitgleich kann so die nötige Reinigungsleistung erreicht werden.

Allgemein gilt vorliegend, dass die Merkmale der genannten Anlage und des Verfahrens bedarfsweise eingesetzt werden können und insbesondere das Verfahren mit der vorstehend beschriebenen Anlage durchgeführt wird.

**Patentansprüche**

1. Anlage zur Behandlung von Behältern aus Kunststoff, insbesondere aus PET, PE, PP oder POC umfassend eine Reinigungsmaschine, wobei die diese mehrere Behandlungsabschnitte aufweist, in welchen das Behälterinnere mit flüssigen Medien gespült werden kann und wobei mindestens einer der Behandlungsabschnitte

   - eine Laugenbehandlung ist, welche eine Heizeinrichtung aufweist und/oder mit einer solchen verbunden ist und
   - ein Behandlungsschritt eine Wasserbehandlung ist,
   wobei stromabwärts der Reinigungsmaschine eine Beschichtungsvorrichtung vorgesehen ist, wobei die Reinigungsmaschine über Transportmittel für die Behälter mit der Beschichtungsvorrichtung verbunden ist,
   **dadurch gekennzeichnet, dass**
   die Beschichtungsvorrichtung eine Gasabscheidevorrichtung mittels Plasma ist, welche mehrere Vakuumkammern aufweist, in welchen die Behälter unter Vakuum beschichtet werden können, und wobei die Vakuumkammer für Gasleitungen mit mindestens zwei unterschiedlichen Prozessgasquellen verbunden ist, und wobei zur Plasma-Bildung mindestens ein Mikrowellengenerator oder mindestens ein Hochfrequenzgenerator vorgesehen ist.

2. Anlage nach Anspruch 1, **dadurch gekennzeichnet, dass** zwischen der Reinigungsmaschine und der Beschichtungsvorrichtung eine weitere Behandlungsmaschine vorgesehen ist, wie eine Trocknungsvorrichtung.

3. Anlage nach Anspruch 2, **dadurch gekennzeichnet, dass** stromaufwärts und stromabwärts der Trocknungsvorrichtung ein Wendevorrichtung für Behälter vorgesehen ist, und die Behälter in der Trocknungsvorrichtung mittels Greifelementen derart gehalten werden, dass die Behältermündung vertikal nach unten weist.

4. Anlage nach einem der vorherigen Ansprüche 1 bis 3, **dadurch gekennzeichnet, dass** zwischen der Reinigungsmaschine und der Beschichtungsvorrichtung außer einer Trocknungsvorrichtung keine weiteren Behandlungselemente für die Behälter angeordnet sind.

5. Anlage nach einem der vorherigen Ansprüche, **dadurch gekennzeichnet, dass** stromabwärts der Beschichtungsvorrichtung weitere Maschinen zum Behandeln von Behältern vorgesehen sind, insbesondere ein Füller, ein Verschließer, eine Dekoriermaschine und/oder eine Verpackungsmaschine.

6. Anlage nach einem der vorherigen Ansprüche, **dadurch gekennzeichnet, dass** eine der Prozessgasquellen mindestens einen Gastanktank oder ein Flüssigkeitstank mit einer Verdampfereinheit umfassen, für Hexamethyldisilazane (HMDSN), Hexamethyldisiloxane (HMDSO) oder Acetylen (Ethin).

7. Anlage nach einem der vorherigen Ansprüche, **dadurch gekennzeichnet, dass** weiterhin mindestens eine Zuleitung für eines der folgenden Gase vorgesehen sind, Sauerstoff (O2), Stickstoff (N2) oder ein Edelgas, insb. Argon (Ar), wobei vorrangig alle vorgenannten Zuleitungen vorgesehen sind.

8. Verfahren zur Behandlung von Behältern aus Kunststoff, insbesondere Behälter aus PET, PE, PP oder POC, wobei in einem ersten Schritt die Behälter, insbesondere das jeweilige Behälterinnere, mittels flüssiger Behandlungsmedien gereinigt werden, wobei mindestens eines der Behandlungsmedien eine Lauge ist, wie NaOH, und mindestens ein Behandlungsmedium Wasser ist, **gekennzeichnet dadurch, dass** in einem nachfolgenden Schritt die Behälter, insbesondere die Behälterinnenwände, mit einem Gasabscheideverfahren beschichtet werden, nämlich mittels eines PCVD-Verfahrens mit mindestens zwei Schichten beschichtet werden, insbesondere Schichten auf der inneren Oberfläche der Behälter, und insbesondere wobei das Plasma mittels Mikrowellengenerator oder Hochfrequenzgenerator induziert wird.

9. Verfahren nach Anspruch 8, **dadurch gekennzeichnet, dass** die Behälter vorlaufend zum ersten Schritt der Reinigung ein Pfand- und Rückführungssystem durchlaufen und als vollständige Behälter zum ersten Schritt der Reinigung transportiert werden.

10. Verfahren nach Verfahrensanspruch 8 oder 9, **dadurch gekennzeichnet, dass** der Generator zur Plasma-Induzierung ein Mikrowellengenerator ist, insbesondere ein Hochfrequenzgenerator, und der mittlere Energieeintrag aus aktiver Pulszeit zur Gesamtpulszeit multipliziert mit der Generatorleistung im Bereich von 10 bis 120 Watt liegt, idealerweise im Bereich von 20 bis 100 Watt.

11. Verfahren nach Verfahrensanspruch 10, **dadurch gekennzeichnet, dass** das die aktive Pulszeit im Bereich von 0.1 ms bis 1 ms liegt und das Verhältnis von aktiver Pulszeit zur Gesamtpulszeit im Bereich von 0,01 bis 0,05 liegt.

12. Verfahren nach einem der vorherigen Verfahrensansprüche, **dadurch gekennzeichnet, dass** auf neu produzierte Behälter vor dem ersten Schritt der Reinigung bereits eine ein oder mehrfach Beschichtung auf die innere Oberfläche aufgetragen wird.

13. Verfahren nach einem der vorherigen Verfahrensansprüche, **dadurch gekennzeichnet, dass** auf neu produzierte Behälter und vor der ersten Befüllung und idealerweise unmittelbar nach der Produktion mindestens ein Dreischichtensystem aus Haftvermittler (Base Coating), Barriereschicht (Barrier Coating) und Schutzschicht (Top Coat) aufgetragen wird, und wobei nach der Verwendung des Behälters und Rückführung der Behälter über ein Pfand- und Rückführungssystem, diese gereinigt werden und anschließend nur teilweise oder ergänzend beschichtet werden, indem

   - mindestens eine weitere Barriereschicht (Barrier Coating) und mindestens eine weitere Schutzschicht (Top Coat) oder
   - nur eine weitere (neue) Schutzschicht (Top Coat) als äußerste Schicht aufgebracht wird.

14. Verfahren nach einem der vorherigen Verfahrensansprüche, **dadurch gekennzeichnet, dass** die Temperatur mindestens eines der Behandlungsmedien für die Behälter, welches eine Lauge ist, im Bereich von 30°C bis 70°C liegt, idealerweise im Bereich von 40°C bis 60°C.

15. Verfahren nach einem der vorherigen Verfahrensansprüche, **dadurch gekennzeichnet, dass** diese unter Verwendung einer Anlage nach einem der Ansprüche 1 bis 7 vorgenommen wird.

**Claims**

1. A system for the treatment of containers made of plastic, in particular, made of PET, PE, PP or POC, comprising a cleaning machine, wherein it has a plurality of treatment stages, in which the container interior can be rinsed with liquid media and wherein at least one of the treatment stages

     - is a lye treatment that comprises a heating device and/or is connected to such a device and
     - a treatment step is a water treatment,

wherein

     a coating device is provided downstream of the cleaning machine, wherein the cleaning machine is connected to the coating device by transport means for the containers, **characterized in that** the coating device is a gas separation device by means of plasma, which comprises a plurality of vacuum chambers in which the containers can be coated under a vacuum, and wherein the vacuum chamber for gas pipelines is connected to at least two different process-gas sources, and wherein at least one microwave generator or at least one high-frequency generator is provided for forming plasma.

2. The system according to Claim 1, **characterized in that** a further treatment machine is provided between the cleaning machine and the coating device, such as a drying device.

3. The system according to Claim 2, **characterized in that** a turning device for containers is provided upstream and downstream of the drying device, and the containers are held in the drying device by means of gripping elements in such a way that the container aperture points vertically downwards.

4. The system according to any one of the preceding Claims 1 to 3, **characterized in that** no other treatment elements for the containers are arranged between the cleaning machine and the coating device other than a drying device.

5. The system according to any one of the preceding claims, **characterized in that** further machines are provided downstream of the coating device for the treatment of containers, in particular, a filler, a capper, a decorating machine and/or a packaging machine.

6. The system according to any one of the preceding claims, **characterized in that** one of the process-gas sources comprises at least one gas tank or one liquid tank with an evaporator unit for hexamethyldisilazane (HMDSN), hexamethyldisiloxane (HMDSO) or acetylene (ethine).

7. The system according to any one of the preceding claims, **characterized in that** at least one supply line is still provided for one of the following gases, oxygen (O2), nitrogen (N2) or a noble gas, in particular Argon (Ar), wherein priority is given to all of the aforementioned supply lines.

8. A method for the treatment of containers made of plastic, in particular, containers made of PET, PE, PP or POC, wherein, at a first step, the containers, in particular, the respective container interior(s), are cleaned by means of liquid treatment media, wherein at least one of the treatment media is a lye, such as NaOH, and at least one treatment medium is water, **characterized in that,** at a subsequent step the containers, in particular, the inner walls of the vessel are coated by a gas separation process, namely by means of a PCVD process with at least two layers, in particular, layers on the inner surface of the containers, and, in particular, wherein the plasma is induced by means of a microwave generator or high-frequency generator.

9. The method according to Claim 8, **characterized in that** the containers pass through a deposit and return system prior to the first step of cleaning and are transported as complete containers to the first step of cleaning.

10. The method according to Method Claim 8 or 9, **characterized in that** the generator for plasma induction is a microwave generator, in particular, a high-frequency generator, and the mean energy input from active pulse time to the total pulse time multiplied by the generator power is within the range of 10 to 120 watts, ideally within the range of 20 to 100 watts.

11. The method according to Method Claim 10, **characterized in that** the active pulse time is within the range of 0.1 ms to 1 ms and the ratio of active pulse time to total pulse time is within the range of 0.01 to 0.05.

12. The method according to any one of the preceding method claims, **characterized in that** a single or multiple coating is already applied to the inner surface of newly produced containers before the first step of cleaning.

13. The method according to any one of the preceding method claims, **characterized in that** at least one three-layer system consisting of an adhesive (base coating), a barrier layer (barrier coating) and a protective layer (top coat) is applied to newly produced containers and before the first filling and ideally immediately after production, and wherein, after the container has been used and the containers are returned by means of the deposit and return system, these are cleaned and then coated only partially or additionally by applying

- at least one additional barrier layer (barrier coating) and at least one additional protective layer (top coat) or
- only another (new) protective layer (top coat) as the outermost layer.

14. The method according to any one of the preceding method claims, **characterized in that** the temperature of at least one of the treatment media for the containers, which is a lye, is within the range of 30 °C to 70 °C, ideally within the range of 40 °C to 60 °C.

15. The method according to any one of the preceding method claims, **characterized in that** it is carried out using a system according to any one of the Claims 1 to 7.

**Revendications**

1. Installation de traitement de récipients en matière plastique, notamment en PET, PE, PP ou POC, comprenant une machine de nettoyage présentant plusieurs sections de traitement dans lesquelles l'intérieur des récipients peut être rincé avec des agents liquides, l'une au moins des sections de traitement

- étant une station de traitement par lessive alcaline présentant un dispositif de chauffage et/ou étant reliée à un tel dispositif, et
- une étape de traitement étant un traitement à l'eau,

un dispositif de revêtement étant prévu en aval de la machine de nettoyage, celle-ci étant reliée au dispositif de revêtement par des moyens de transport pour les récipients, **caractérisée en ce que** le dispositif de revêtement est un dispositif de dépôt en phase gazeuse au moyen d'un plasma présentant plusieurs chambres à vide dans lesquelles les récipients peuvent être munis sous vide d'un revêtement, la chambre à vide étant reliée par des conduites de gaz à au moins deux sources de gaz de procédé différentes et un générateur de micro-ondes au moins ou un générateur haute fréquence au moins étant prévu pour la production du plasma.

2. Installation selon la revendication 1, **caractérisée en ce qu'**une machine de traitement, comme un dispositif de séchage, est prévue entre la machine de nettoyage et le dispositif de revêtement.

3. Installation selon la revendication 2, **caractérisée en ce qu'**un dispositif de retournement des récipients est prévu en amont et en aval du dispositif de séchage et que les récipients sont maintenus dans le dispositif de séchage au moyen d'éléments de préhension de façon à ce que l'embouchure des récipients soit dirigée verticalement vers le haut.

4. Installation selon l'une des revendications 1 à 3, **caractérisée en ce qu'**aucun élément de traitement autre que le dispositif de séchage n'est agencé entre la machine de nettoyage et le dispositif de revêtement.

5. Installation selon l'une des revendications précédentes, **caractérisée en ce qu'**en aval du dispositif de revêtement sont prévues d'autres machines de traitement des récipients, notamment un dispositif de remplissage, un dispositif de fermeture, une machine à décorer et/ou une machine à emballer.

6. Installation selon l'une des revendications précédentes, **caractérisée en ce que** l'une des sources de gaz de procédé comprend au moins un réservoir à gaz ou liquide avec une unité d'évaporation pour contenir de l'hexaméthyldisilazane (HMDSN), de l'hexaméthyldisiloxane (HMDSO) ou de l'acétylène.

7. Installation selon l'une des revendications précédentes, **caractérisée en ce qu'**est prévue au moins une conduite d'amenée de l'un des gaz suivants : de l'oxygène ($O_2$), de l'azote ($N_2$) ou un gaz rare, notamment de l'argon (Ar), et préférentiellement toutes les conduites d'amenée précitées.

8. Procédé de traitement de récipients en matière plastique, notamment en PET, PE, PP ou POC, une première étape consistant à nettoyer les récipients, notamment à en nettoyer l'intérieur au moyen d'agents de traitement liquides, l'un au moins des agents de traitement étant une lessive alcaline comme le NaOH et un agent de traitement au moins étant de l'eau, **caractérisé en ce qu'**au cours d'une étape suivante les récipients et notamment leurs parois intérieures sont munis d'un revêtement par un procédé de dépôt en phase gazeuse, à savoir au moyen d'un processus PCVD, le revêtement comportant au moins deux couches, notamment des couches sur la surface intérieure des récipients, le plasma étant notamment obtenu au moyen d'un générateur de micro-ondes ou d'un générateur haute fréquence.

9. Procédé selon la revendication 8, **caractérisé en ce que** les récipients parcourent avant la première étape de nettoyage un système de consigne et de retour et sont transportés comme récipients entiers vers la première étape de nettoyage.

10. Procédé selon la revendication de procédé 8 ou 9, **caractérisé en ce que** le générateur de plasma est un générateur de micro-ondes, notamment un générateur haute fréquence, et que l'apport moyen d'énergie d'impulsion active par rapport à la durée totale d'impulsion multiplié par la puissance du générateur est comprise entre 10 et 120 watts, idéalement entre 20 et 100 watt.

11. Procédé selon la revendication de procédé 10, **caractérisé en ce que** la durée d'impulsion active est comprise entre 0,1 ms et 1 ms et le rapport de la durée active à la durée totale est compris entre 0,01 et 0,05.

12. Procédé selon l'une des revendications de procédé précédentes, **caractérisé en ce qu'**un revêtement simple ou multiple est déjà appliqué sur la surface intérieure des récipients nouvellement produits dès avant la première étape de nettoyage.

13. Procédé selon l'une des revendications de procédé précédentes, **caractérisé en ce qu'**un système de trois couches comportant un agent de pontage (Base Coating), une couche formant barrière (Barrier Coating) et une couche de protection (Top Coat) est appliqué sur les récipients nouvellement produits, les récipients retournés après utilisation par un système de consigne et de retour étant nettoyés, après quoi ils ne reçoivent qu'un revêtement partiel ou complémentaire en ce que

   - une couche barrière (Barrier Coating) supplémentaire au moins et une couche de protection (Top Coat) supplémentaire au moins ou
   - uniquement une autre (nouvelle) couche de protection (Top Coat) sont appliquées sur la couche externe.

14. Procédé selon l'une des revendications de procédé précédentes, **caractérisé en ce que** la température d'au moins l'un des agents de traitement des récipients, à savoir d'une lessive alcaline, est comprise entre 30 °C et 70 °C, idéalement entre 40 °C et 60 °C.

15. Procédé selon l'une des revendications de procédé précédentes, **caractérisé en ce que** celles-ci sont réalisées par la mise en oeuvre d'une installation selon l'une des revendications 1 à 7.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2009118139 A1
- WO 2009124688 A1
- DE 102012213079 A1
- US 5849366 A